## Europäisches Patentamt

## European Patent Office

## Office européen des brevets

(19)

(11) Numéro de publication: **0 031 283 B1**

## (12) FASCICULE DE BREVET EUROPEEN

(45) Date de publication du fascicule du brevet: **16.05.84**

(51) Int. Cl.³: **H 02 H 7/20**, H 02 H 9/02, H 02 H 9/04, H 01 L 25/16

(21) Numéro de dépôt: **80401811.7**

(22) Date de dépôt: **17.12.80**

(54) Circuit de protection d'un circuit de commutation.

(30) Priorité: **21.12.79 FR 7931481**

(43) Date de publication de la demande: **01.07.81 Bulletin 81/26**

(45) Mention de la délivrance du brevet: **16.05.84 Bulletin 84/20**

(84) Etats contractants désignés: **DE FR GB**

(56) Documents cités:
**FR - A - 1 441 855**
**FR - A - 2 267 000**
**FR - A - 2 293 070**
**US - A - 4 099 216**

(73) Titulaire: **LIGNES TELEGRAPHIQUES ET TELEPHONIQUES L.T.T., 1, rue Charles Bourseul, F-78702 Conflans-Ste-Honorine (FR)**

(72) Inventeur: **Blangeard, Gérard, THOMSON-CSF SCPI 173, bld Haussmann, F-75360 Paris Cedex 08 (FR)**
Inventeur: **Bulte, Jean-Claude, THOMSON-CSF SCPI 173, bld Haussmann, F-75360 Paris Cedex 08 (FR)**
Inventeur: **Lerault, Raymond, THOMSON-CSF SCPI 173, Bld Haussmann, F-75360 Paris Cedex 08 (FR)**

(74) Mandataire: **Benoit, Monique et al, THOMSON-CSF SCPI 173, Bld Haussmann, F-75379 Paris Cedex 08 (FR)**

BUNDESDRUCKEREI BERLIN

Circuit de protection d'un circuit de commutation et son application

La présente invention concerne un circuit de protection d'un circuit de commutation et notamment d'un transistor de commutation contre des fausses manoeuvres (par exemple court-circuit de la charge) et/ou contre des signaux parasites à haut niveau, tels que peuvent en provoquer le secteur notamment par induction ou la foudre par exemple. Ce problème a donné lieu à de nombreuses solutions utilisant à la fois les propriétés de résistances variant avec la température et/ou de résistances variant avec la tension appliquée à leur borne (respectivement désignées par TCR et VCR dans la littérature anglo-saxonne).

L'article intitulé »Thick film and high voltages« publié page 162 du numéro de Novembre 1979 de la revue Electronic Engineering est consacré au compte rendu d'études faites sur le comportement de circuits hybrides à couches épaisses vis-à-vis de tensions de l'ordre de 220 V. Il en résulte que des circuits de protection efficaces et peu coûteux sont difficiles à réaliser en pratique. D'autre part, les diodes de protection dont sont généralement munis les circuits de commutation ne peuvent les protéger que contre des perturbations d'une seule polarité et laissent le champ libre à leur destruction par des perturbations de polarité inverse.

La présente invention concerne un schéma d'un circuit de protection qui peut être réalisé suivant diverses technologies.

Elle consiste en un circuit comportant des composants rapportés et éventuellement des éléments de circuits hybrides de préférence à couche mince. Un tel circuit permet une réalisation de faible prix de revient tout en assurant des performances sévères et une bonne protection face à des surtensions (par exemple application d'une tension de 220 V au circuit, application d'impulsions de 1000 V de quelques ms) et/ou à des surintensités (par exemple court-circuit de la charge).

On connaît de l'antériorité US-A-4 099 216 un circuit de protection comprenant au moins deux résistances connectées en série, la première étant fixe et constituant une première branche série et la deuxième étant variable avec la température suivant un coefficient de température positif et constituant une deuxième branche série, et un élément variable avec la tension connecté au point commun entre les première et deuxième branches série de manière à constituer une branche parallèle. L'invention a pour objet un dispositif de protection du type précité présentant un temps de réponse amélioré en ce qui concerne l'élément variable avec la température.

Dans ce but, il est caractérisé en ce que l'élément variable avec la tension est une troisième résistance, en ce que les extrémités de la première branche série et de la branche parallèle sont destinées à recevoir les sorties dudit circuit de commutation, en ce que les extrémités de la deuxième branche série et de la branche parallèle sont destinées à recevoir une charge, et en ce que lesdites résistances sont disposées sur un substrat thermiquement conducteur de telle façon que la deuxième résistance variable avec la température soit disposée à proximité d'au moins une des autres résistances de manière que cette dernière abaisse le temps de réponse thermique de la deuxième résistance par effet de chauffage.

Selon une variante avantageuse, la deuxième branche série comporte une quatrième résistance fixe disposée en série avec la deuxième résistance qui est variable avec la température.

Selon un mode de réalisation avantageux, le circuit de protection est réalisé sous forme de circuit hybride, notamment à couches minces, et comporte au moins une résistance fixe déposée, notamment sous forme de couche mince, les autres résistances étant rapportées.

On connaît de l'antériorité FR-A-2 293 070 un circuit intégré à couches épaisses comprenant un substrat céramique comportant sur une de ses faces des conducteurs et une résistance fixe imprimée et sur son autre face, une résistance imprimée destinée à la constitution d'une résistance variable, de telle sorte que la densité des composants puisse être accrue.

Selon un mode préféré de l'invention, on met à profit la technique double face pour obtenir l'effet de chauffage recherché.

Dans ce but, le circuit intégré est double face et comporte sur une face au moins une résistance fixe et sur l'autre face les résistances rapportées de telle sorte que la conduction thermique du substrat assure ledit effet de chauffage de la deuxième résistance variable avec la température.

La valeur de la ou des résistances de la deuxième branche série peut être choisie de manière telle qu'elle soit suffisante pour que la tension aux bornes de la troisème résistance soit inférieure à la tension de claquage du circuit de commutation à protéger lorsqu'une tension anormale, par exemple sous forme d'une tension alternative pulsée ou d'une tension de foudre, est présente entre les extrémités de la branche parallèle et de la deuxième branche série.

— La fig. 1 est un schéma électrique selon l'invention.
— La fig. 2 est la vue d'une première face du circuit hybride selon un mode de réalisation de l'invention.
— La fig. 3 est la vue de la deuxième face du circuit hybride de la fig. 2.

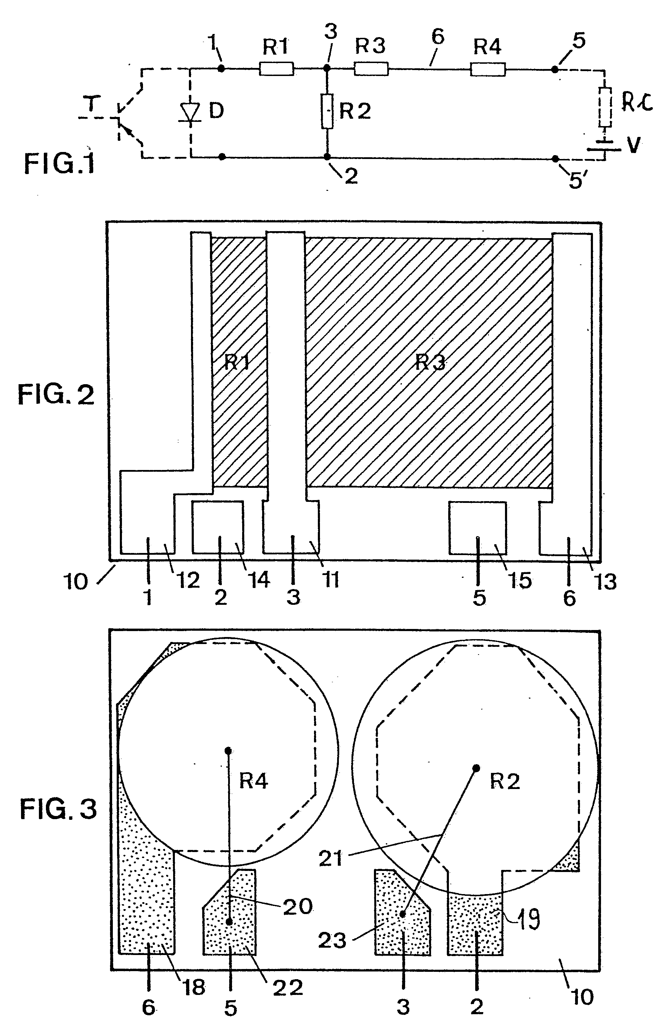

La fig. 1 représente, en pointillé, un transistor de commutation T, pourvu d'une diode D de protection et qu'il convient, à titre d'exemple, de protéger contre des surtensions et/ou des surintensités. La partie droite de la figure montre, en pointillé également, la charge $R_c$ par exemple résistive et la source de tension V d'alimentation du transistor T. Le circuit de protection est représenté en trait plein. Il est constitué d'au moins deux résistances $R_1$ et $R_4$, et éventuellement d'une résistance $R_3$ connectées en série dans le circuit collecteur du transistor T entre celui-ci et l'impédance de charge $R_c$. La résistance $R_1$ constitue une première branche série, et la résistance $R_4$, à laquelle est éventuellement associée une résistance $R_3$, constitue une deuxième branche série. Une quatrième résistance $R_2$ est connectée en parallèle entre l'émetteur de T et le point commun 3 aux résistances $R_1$ et $R_4$ ou $R_3$, et constitue une branche parallèle. La résistance $R_2$ est une résistance variant avec la tension et destinée à limiter la tension aux bornes du transistor et la résistance $R_4$ est une résistance à coefficient de température positif destinée à limiter le courant, suivant des modalités qui seront explicitées plus loin.

Les fig. 2 et 3 représentent les deux vues de face du circuit selon un mode de réalisation de l'invention avant l'encapsulation qui consiste habituellement à déposer une couche de résine époxy. Ce circuit est constitué d'un substrat isolant de préférence thermiquement conducteur 10, sur l'une des faces duquel sont déposées les deux résistances fixes $R_1$ et $R_3$ sous forme de couches minces, par exemple de nitrure de tantale, ainsi qu'il est bien connu de l'homme de l'art, ce qui conduit à des tolérances (de $\pm 20\%$ environ) satisfaisantes pour l'application envisagée. Les résistances $R_1$ et $R_3$ sont connectées en série à l'une de leurs extrémités par le conducteur 11 en contact avec la broche 3. A titre d'exemple, la résistance $R_3$ est de forme carrée, la résistance $R_1$ étant de forme rectangulaire et la longueur de $R_1$ est égale au côté du carré de $R_3$. L'autre extrémité de $R_1$ est reliée au contact 12 et à la broche 1. L'autre extrémité de $R_3$ est de la même façon reliée par le contact 13 à la broche 6. La plaquette porte deux autres contacts respectivement 14 et 15 reliés aux broches 2 et 5.

Selon une variante préférée de l'invention, les contacts sont constitués en un alliage platine-or sur un substrat généralement en verre ou en alumine ainsi qu'il est décrit dans le brevet français 2 290 762 déposé par la Demanderesse et publié le 4 juin 1976 pour: »Procédé de réalisation de contacts ohmiques pour circuits en couche mince«.

La fig. 3 représente la deuxième face de la plaquette 10; les éléments communs aux deux faces, à savoir, les broches, portent les mêmes numéros de référence que sur la fig. 2. Sur la deuxième face de la plaquette sont rapportées les résistances $R_2$ et $R_4$ par exemple par soudure sur des plages métallisées conductrices respectivement 18 et 19. Les deuxièmes extrémités des résistances sont réunies par des conducteurs respectivement 20 et 21 aux plages conductrices 22 et 23 en contact avec les broches 3 et 5.

Sur la fig. 2, les résistances à couche mince couvrent la presque totalité de la surface du substrat. Il est en effet avantageux du point de vue encombrement d'utiliser le plus petit type de substrat compatible avec la surface nécessaire pour obtenir en couche mince les valeurs désirées des résistances, tout en assurant l'évacuation de l'énergie dissipée dans le circuit qui peut être le cas échéant importante. L'utilisation d'un circuit double face sur substrat thermiquement conducteur permet de diminuer le temps de réponse thermique de la résistance $R_4$, du fait que celle-ci se trouve également chauffée par les autres résistances du circuit.

Il va de soi que le mode de réalisation décrit ci-dessus n'est donné qu'à titre d'exemple non limitatif. Ainsi, le circuit peut être du type simple face. Pour utiliser dans ce cas également le phénomène de chauffage de la résistance $R_4$ par le reste du circuit, il suffit de disposer les résistances assez proches les unes des autres, par exemple en entourant $R_4$ d'une résistance annulaire à couche mince ($R_1$ ou $R_3$). Le circuit peut être également réalisé sur un circuit hybride à couches épaisses simple ou double face dans la mesure où les incidents de fonctionnements prévisibles pour le circuit ne correspondent pas à des tensions électriques et/ou des surintensités trop élevées.

D'autre part, une réalisation sur circuit imprimé à l'aide de composants discrets peut être envisagée si les contraintes d'encombrement ne sont pas sévères et/ou si les puissances en jeu ne sont pas trop importantes.

On va maintenant préciser les critères permettant de déterminer pratiquement les valeurs des éléments constitutifs du circuit suivant l'invention, en rapport avec les conditions de fonctionnement anormales que le circuit est susceptible de subir.

1. En premier lieu, considérons l'éventualité de la mise en court-circuit de la charge. La tension V du générateur va donner lieu à un courant

$$I_0 = \frac{V}{R_1 + (R_3 + R_4\,(T_0))}$$

traversant le transistor T dans le cas où celui-ci est saturé. Le passage d'un courant $I_0$ dans la résistance $R_4$ va échauffer celle-ci à une température $T_1$ et sa résistance va augmenter, d'où diminution du courant jusqu'à une valeur stable

$$I_1 = \frac{V}{R_1 + (R_3 + R_4\,(T_1))} \qquad (1)$$

La somme des résistances $R_1 + (R_3 + R_4\,(T_0))$ devra donc être choisie pour que le courant $I_0$ passant dans le transistor ne soit pas susceptible de détériorer celui-ci au moins pendant le temps que mettra le courant $I_0$ pour décroître de manière substantielle. Le courant $I_1$ correspondra à une puissance relativement faible que dissipera le circuit si le court-circuit se prolonge.

2. Considérons l'application aux bornes 5,5' d'une tension élevée (par exemple 200 V. efficaces), de manière pulsée et répétitive. Dans le cas où le transistor est bloqué, il est important que la tension aux bornes de $R_2$ soit inférieure à la tension de claquage du transistor 1. L'échauffement relativement rapide de la résistance $R_4$ assurera ensuite une baisse corrélative de la tension aux bornes de $R_2$. La présence de $R_1$ contribue à limiter le courant dans le transistor T lorsque celui-ci est saturé.

3. Considérons enfin l'application d'une tension de foudre $V_f$ de courte durée correspondant à des effets secondaires induits de la foudre (par exemple 1000 V pendant quelques ms). Comme dans le cas précédent, la tension aux bornes de $R_2$ doit être inférieure à la tension de claquage du transistor T à la chute de tension près dans la résistance $R_1$. Etant donné que dans ce cas, la tension et donc la dissipation est beaucoup plus élevée que dans le cas précédent, l'échauffement de la résistance $R_4$ sera bien plus rapide.

On choisira par exemple les paramètres des éléments du circuit de la manière suivante:

a) La condition la plus exigeante en ce qui concerne la tension aux bornes de $R_2$ est donnée, le cas échéant, par le test de foudre à la tension $V_f$. On choisira une tension maximum acceptée $V_{ma}$ aux bornes de la résistance $R_2$, et on en déduira la valeur de $R_2 = R_2 (V_{ma})$ sur sa caractéristique.

On aura alors, $R_2$, $R_3$ et $R_4$ formant un pont diviseur:

$$(R_3 + R_4) \geq R_2 (V_{ma}) \left( \frac{V_f - V_{ma}}{V_{ma}} \right) \qquad (2)$$

b) On choisira $R_1$ de telle manière que le courant dans le transistor T ne soit pas trop élevé lorsque la tension $V_{ma}$ est présente aux bornes de $R_2$ et lorsque le transistor T est saturé. $I_{max}$ étant le courant maximal toléré dans le transistor, on choisira $R_1$ en appliquant en première approximation la formule:

$$R_1 \geq \frac{V_{ma} - V_{ce} (I_{max})}{I_{max}} \qquad (3)$$

où $V_{ce} (I_{max})$ est la tension entre le collecteur et l'émetteur de T qui correspond à $I_{max}$.

Si on veut tenir compte de la variation de $R_2$ avec la tension, on peut soit calculer la valeur de $R_1$ en utilisant une formule approchée de la loi de variation de $R_2$ ou bien, de manière expérimentale, déterminer la valeur de $R_1$ pour que le courant qui traverse le circuit de commutation à protéger ne dépasse pas $I_{max}$.

Dans ces conditions, le courant $I_0$ défini lors du test de courtcircuit de la charge sera en général intérieur au courant qui peut traverser le transistor T.

Ainsi que les calculs ci-dessus le montrent, la somme $R_3 + R_4$ est significative d'une des conditions aux limites que doit satisfaire le circuit. Il en résulte que la présence de la résistance $R_3$ n'est pas absolument nécessaire dans le cas où est disponible commercialement une résistance $R_4$ dont la valeur à température ordinaire satisfait la condition:

$$R_4 \geq R_2 (V_{ma}) \left( \frac{V_f - V_{ma}}{V_{ma}} \right) \qquad (2')$$

Toutefois, une résistance $R_3$ peut également être utilisée au vu de considérations sur la dissipation thermique dans le circuit de protection et/ou éviter une augmentation significative de la valeur de $R_4$ dans les conditions normales de fonctionnement.

On notera que, pour des raisons de dissipation thermique dans des conditions normales de fonctionnement, on choisira la somme des valeurs des résistances $(R_1 + R_4)$, ou le cas échéant $(R_1 + R_3 + R_4)$, de telle sorte que celle-ci soit assez sensiblement inférieure à la résistance $R_C$ de la charge.

On va maintenant décrire, à titre d'exemple non limitatif, un exemple de réalisation où on calcule les valeurs des éléments en utilisant les critères ci-dessus.

Le transistor à protéger est du type BDW 92 vendu par la Société SGS-ATES et alimentant une charge de 1000 Ω!

Il peut tenir une tension de 180 V à l'état bloqué et être traversé sans inconvénient par un courant de 4 A en permanence et de l'ordre de 10 A instantané lorsqu'il est saturé.

On a choisi pour $R_2$ une résistance de référence VZR 048— 003 VA fabriquée par la Société L.C.C.— C.I.C.E.

$R_4$ est une résistance à coefficient de température positif fabriquée par la Société RTC et dont la valeur à la température ambiante est de 80 Ω, cette valeur atteignant 2500 Ω, à 110° C.

La condition (2) s'exprime en prenant $V_{ma} = 120$ V.

$$(R_3 + 80) \geq \frac{880}{120} \times 16 = 120 \ \Omega.$$

Soit:

$$R_3 = 40 \ \Omega.$$

D'autre part, on choisira $R_1$ en utilisant la formule (3) pour les conditions de fonctionnement les plus sévères, à savoir $V_{ma} = 120$ V et en limitant $I_{max}$ à 7,5 A. Dans ces conditions, $V_{ce} = 70$ V (déterminé par les caractéristiques du transistor)

$$R_1 \geq \frac{50}{7,5} = 6,7 \ \Omega.$$

Avec $R_1 = 10\ \Omega$, le courant sera limité à 5 A.

Les valeurs choisies introduisent une résistance série de 130 $\Omega$ qui est très inférieure à l'impédance de la charge qui est égale à 1000 $\Omega$.

Dans la description ci-dessus, on a envisagé, à titre d'exemple, le cas où le circuit de commutation à protéger était un circuit à semi-conducteurs symbolisé sous la forme d'un transistor. L'invention s'applique à la protection de tous les circuits de commutation et notamment aux contacts de relais. On rappellera à cet égard que les contacts de relais comportent, au même titre que les circuits semi-conducteurs, des limitations en ce qui concerne la tension maximale de fonctionnement et le courant maximal qui peut les traverser.

## Revendications

1. Circuit de protection d'un circuit de commutation comprenant au moins deux résistances ($R_1$, $R_4$) connectées en série, la première ($R_1$) étant fixe et constituant une première branche série et la deuxième ($R_4$) étant variable avec la température suivant un coefficient de température positif et constituant une deuxième branche série, et un élément variable avec la tension connecté au point commun entre lesdites première et deuxième branches série de manière à constituer une branche parallèle, caractérisé en ce que ledit élément variable avec la tension est une troisième résistance ($R_2$), en ce que les extrémités de la première branche série et de la branche parallèle sont destinées à recevoir les sorties dudit circuit de commutation, en ce que les extrémités de la deuxième branche série et de la branche parallèle sont destinées à recevoir une charge ($R_C$), et en ce que lesdites résistances sont disposées sur un substrat thermiquement conducteur de telle façon que la deuxième résistance ($R_4$) variable avec la température soit disposée à proximité d'au moins une des autre résistances ($R_1$, $R_2$) de manière que cette dernière ($R_1$, $R_2$) abaisse le temps de réponse thermique de la deuxième résistance ($R_4$) par effet de chauffage.

2. Circuit selon la revendication 1, caractérisé en ce que la deuxième branche série comporte une quatrième résistance ($R_3$) fixe disposée en série avec la deuxième résistance ($R_4$) variable avec la température.

3. Circuit selon une des revendications 1 ou 2, caractérisé en ce qu'il est réalisé sous forme de circuit hybride et en ce qu'il comporte au moins une résistance fixe ($R_1$, $R_3$) déposée, les autres résistances étant rapportées ($R_2$, $R_4$).

4. Circuit selon la revendication 3, caractérisé en ce que le circuit hybride est double face et comporte sur unte face au moins une résistance fixe ($R_1$, $R_3$) et sur l'autre face les résistances rapportées ($R_2$, $R_4$) de telle sorte que la conduction thermique du substrat assure ledit effet de chauffage de la deuxième résistance ($R_4$) variable avec la température.

5. Circuit selon une revendications 3 ou 4, caractérisé en ce que le circuit hybride est à couches minces.

6. Circuit selon une des revendications précédentes, caractérisé en ce que la valeur de la ou des résistances ($R_3$, $R_4$) de la deuxième branche série est choisie de manière telle qu'elle soit suffisante pour que la tension aux bornes de la troisième résistance ($R_2$) soit inférieure à la tension de claquage du circuit de commutation à protéger lorsqu'une tension anormale est présente entre les extrémités de la branche parallèle et de la deuxième branche série.

7. Circuit selon la revendication 5, caractérisé en ce que ladite tension anormale est une tension alternative pulsée ou une tension de foudre.

## Patentansprüche

1. Schaltung zum Schutz eines Schaltkreises mit mindestens zwei in Reihe geschalteten Widerständen ($R_1$, $R_4$), von denen der erste ($R_1$) ein Festwiderstand ist und einen ersten Serienzweig bildet, während der zweite ($R_4$) mit positivem Temperaturkoeffizient temperaturabhängig ist und einen zweiten Serienzweig bildet, und mit einem spannungsabhängigen Element, das an den gemeinsamen Punkt der beiden Serienzweige so angeschlossen ist, daß es einen Parallelzweig bildet, dadurch gekennzeichnet, daß das spannungsabhängige Element als dritter Widerstand ($R_2$) ausgebildet ist, daß die Enden des ersten Serienzweigs und des Parallelzweigs dazu bestimmt sind, die Ausgänge des Schaltkreises zugeführt zu erhalten, daß die Enden des zweiten Serienzweigs und des Parallelzweigs dazu bestimmt sind, an eine Last ($R_C$) angeschlossen zu werden, und daß die Widerstände so auf einem wärmeleitenden Substrat angebracht sind, daß der zweite temperaturabhängige Widerstand ($R_4$) in der Nähe mindestens eines der anderen Widerstände ($R_1$, $R_2$) liegt, so daß dieser letztere Widerstand ($R_1$, $R_2$) die thermische Ansprechzeit des zweiten Widerstands ($R_4$) durch Heizwirkung absenkt.

2. Schaltung nach Anspruch 1, dadurch gekennzeichnet, daß der zweite Serienzweig einen festen vierten Widerstand ($R_3$) enthält, der in Reihe mit dem temperaturabhängigen zweiten Widerstand ($R_4$) angeordnet ist.

3. Schaltung nach einem der Ansprüche 1 oder 2, dadurch gekennzeichnet, daß sie als Hybridschaltung ausgeführt ist und mindestens einen festen Widerstand ($R_1$, $R_3$) aufweist, der als Schicht vorliegt, während die beiden anderen Widerstände ($R_2$, $R_4$) aufgesteckt sind.

4. Schaltung nach Anspruch 3, dadurch gekennzeichnet, daß die hybride Schaltung auf zwei Seiten aufgebracht ist und auf der ersten Seite mindestens einen Festwert-Widerstand ($R_1$, $R_3$) sowie auf der anderen Seite die aufgesteckten Widerstände ($R_2$, $R_4$) aufweist, derart, daß die Wärmeleitung des Substrats die Aufheizung des zweiten, temperaturabhängigen Wi-

derstands (R$_4$) bewirkt.

5. Schaltung nach einem der Ansprüche 3 oder 4, dadurch gekennzeichnet, daß die Hybridschaltung eine Dünnschicht-Schaltung ist.

6. Schaltung nach einem der vorhergehenden Ansprüche, dadurch gekennzeichnet, daß der Wert des oder der Widerstände (R$_3$, R$_4$) des zweiten Serienzweigs so groß gewählt ist, daß die Spannung an den Enden des dritten Widerstands (R$_2$) geringer als die Durchschlagspannung des zu schützenden Schaltkreises ist, wenn eine abnorm große Spannung zwischen den Enden des Parallelzweiges und des zweiten Serienzweigs anliegt.

7. Schaltung nach Anspruch 5, dadurch gekennzeichnet, daß die abnorm große Spannung eine gepulste Wechselspannung oder eine Blitzspannung ist.

**Claims**

1. A circuit for the protection of a switching circuit, comprising at least two series connected resistors (R$_1$, R$_4$), the first one (R$_1$) having a fixed value and constituting a first series branch whereas the second one (R$_4$) varies with the temperature according to a positive temperature coefficient and constitutes a second series branch, and comprising an element which varies with the voltage and is connected to the common point of the first and the second series branch so as to constitute a parallel branch, characterized in that said element which varies with the voltage is a third resistor (R$_2$), that the terminals of the first series branch and of the parallel branch are intended to receive the outputs of said switching circuit, that the terminals of the second series branch and of the parallel branch are intended to receive a charge (R$_C$) and that said resistors are disposed on a thermally conducting substrate in such a manner that the second resistor (R$_4$) which varies with the temperature is disposed close to at least one of the remaining resistors (R$_1$, R$_2$) so that the last mentioned resistor (R$_1$, R$_2$) lowers the thermal response time of the second resistor (R$_4$) by heating.

2. A circuit according to claim 1, characterized in that the second series branch comprises a fourth resistor (R$_3$) having a fixed value and disposed in series connection with the second resistor (R$_4$) which varies with the temperature.

3. A circuit according to one of claims 1 or 2, characterized in that it is realized as hybrid circuit and that it comprises at least one layer resistor (R$_1$, R$_3$) having a fixed value, whereas the other resistors (R$_2$, R$_4$) are resistor components.

4. A circuit according to claim 3, characterized in that the hybrid circuit is a double face circuit and comprises on one face at least one resistor (R$_1$, R$_3$) having a fixed value and on the other face the component resistors (R$_2$, R$_4$) in such a way that the thermal conduction of the substrate ensures said heating effect of the second resistor (R$_4$), the value of which varies with the temperature.

5. A circuit according to one of claims 3 or 4, characterized in that the hybrid circuit is a thin layer circuit.

6. A circuit according to one of the preceding claims, characterized in that the value of the resistor or resistors (R$_3$, R$_4$) of the second series branch is selected in such a way that it is high enough for limiting the voltage at the terminals of the third resistor (R$_2$) to a value which is lower than the breakthrough voltage of the switching circuit which is to be protected when an abnormal votage is present between the terminals of the parallel branch and the second series branch.

7. A circuit according to claim 5, characterized in that the abnormal voltage is a pulsed alternating voltage or a thunderbolt voltage.

FIG.1

FIG. 2

FIG. 3